# EUROPEAN PATENT SPECIFICATION

(11) **EP 4 451 826 B1**
(45) Date of publication and mention of the grant of the patent: **02.12.2026**
(21) Application number: 22907683.1
(22) Date of filing: 27.10.2022
(51) Int. Cl.: H10D 86/40, H10K 59/121, H10D 86/60, H10D 30/67

(54) **DISPLAY DEVICE AND MANUFACTURING METHOD THEREFOR**
ANZEIGEVORRICHTUNG UND HERSTELLUNGSVERFAHREN DAFÜR
DISPOSITIF D'AFFICHAGE ET SON PROCÉDÉ DE FABRICATION

(30) Priority: 13.12.2021 KR 20210177412
(43) Date of publication of application: 23.10.2024
(73) Proprietor: Samsung Display Co., Ltd., Yongin-si, Gyeonggi-do 17113 (KR)
(72) Inventor: SOHN, Sangwoo, Yongin-Si Gyeonggi-do 17113 (KR); MOON, Yeon Keon, Yongin-Si Gyeonggi-do 17113 (KR); KIM, Eun Hyun, Yongin-Si Gyeonggi-do 17113 (KR); YANG, Seungho, Yongin-Si Gyeonggi-do 17113 (KR); LIM, Jun Hyung, Yongin-Si Gyeonggi-do 17113 (KR); JEONG, Hyunjun, Yongin-Si Gyeonggi-do 17113 (KR)
(74) Representative: Marks & Clerk LLP
(86) International application number: PCT/KR2022/016571
(87) International publication number: WO 2023/113212

(56) References cited:
- KR-A- 20180 012 442
- KR-A- 20200 004 344
- KR-A- 20200 023 573
- KR-A- 20210 028 318
- US-A1- 2018 069 190
- US-A1- 2019 081 077
- US-A1- 2019 288 048
- US-A1- 2021 104 558
- US-A1- 2021 242 249
- US-B2- 9 240 485

## Description

### TECHNICAL FIELD

The present disclosure herein relates to a display device and a method for manufacturing the same, and particularly, to a display device having an oxide transistor and a method for manufacturing the same.

### BACKGROUND ART

A display device includes a plurality of pixels and a driving circuit (for example, a scan driving circuit and a data driving circuit) which controls the plurality of pixels. The plurality of pixels each include a display element and a pixel circuit which controls the display element. The pixel circuit may include a plurality of transistors organically connected to each other.

The plurality of transistors may each include a silicon semiconductor, or a metal oxide semiconductor.

US 2021/0242249 A1 discloses a display apparatus includes a substrate; a thin-film transistor on the substrate, where the thin-film transistor includes a semiconductor layer and a gate electrode overlapping the semiconductor layer with a first insulating layer between the gate electrode and the semiconductor layer; and a display element electrically connected to the thin-film transistor. The gate electrode includes a first lower layer and a first upper layer on the first lower layer and including a different material from the first lower layer. The first lower layer has a first thickness from an upper surface of the first insulating layer,
and the first upper layer has a second thickness from an upper surface of the first lower layer, where the second thickness is greater than the first thickness.

US 2019/0081077 A1 discloses an active matrix substrate includes a substrate, a TFT-containing layer which is supported on the substrate, and which includes a gate electrode, a gate insulating layer, a semiconductor layer, and source and drain electrodes of the TFT, a metal wiring layer which is supported on the substrate and has a thickness of 400 nm or more, and an inorganic insulating layer which is thinner than the metal wiring layer, and is arranged on a substrate side of the metal wiring layer and is in contact with a lower surface of the metal wiring layer. The metal wiring layer has tensile stress and the inorganic insulating layer has compressive stress, and a ratio Sb/Sa of an absolute value Sb of a stress value of the inorganic insulating layer to an absolute value Sa of a stress value of the metal wiring layer is 0.6 or more and 1.7 or less.

US 2019/0288048 A1 discloses a display apparatus includes a substrate including a display area; a first thin film transistor arranged on the display area of the substrate and having a first semiconductor layer including a silicon semiconductor and a first gate electrode insulated from the first semiconductor layer by a first gate insulating layer; a second thin film transistor arranged on the display area of the substrate and having a second semiconductor layer including an oxide semiconductor and a second gate electrode insulated from the second semiconductor layer; and a storage capacitor at least partially overlapping the first thin film transistor and having a lower electrode and an upper electrode, wherein the second semiconductor layer and one of the lower electrode and the upper electrode are arranged on a same layer.

US 2018/0069190 A1 discloses a display device includes a base substrate, a first transistor, a second transistor, an organic light emitting diode, and a capacitor electrically
connected to the first thin film transistor. The first transistor includes a first semiconductor pattern below a first interlayer insulation layer and a first control electrode above the first interlayer insulation layer and below a second interlayer insulation layer. The second transistor includes a second control electrode above the first interlayer insulation layer and below the second interlayer insulation layer. A second semiconductor pattern is above the second interlayer insulation layer.

### DISCLOSURE OF THE INVENTION

### TECHNICAL PROBLEM

The present disclosure provides a display device including an oxide transistor having a wide driving voltage range.

The present disclosure also provides a method for manufacturing the display device.

### TECHNICAL SOLUTION

The invention is defined in independent claims 1, 9 and 13. Preferred embodiments are defined in the independent claims.

### ADVANTAGEOUS EFFECTS

According to what is described above, in the forming of a metal oxide pattern, oxygen is injected into an insulating layer which covers a metal oxide semiconductor pattern. The oxygen diffuses to a source region and a drain region of the metal oxide semiconductor pattern, and reduces carriers in the source region and the drain region. The resistances of the source region and the drain region with reduced carriers increase, thus causing the voltage-current characteristics of an oxide transistor to be changed. The oxide transistor may have a wider driving voltage range.

The injected oxygen may diffuse to a channel region. Particularly, the oxygen may diffuse to an edge region of the channel region exposed by a gate. The diffused oxygen removes oxygen deficiency in the edge region of the channel region. Since oxygen deficiency is removed and hydrogen bonded thereto is reduced, a carrier concentration in an external region of the channel region is not increased. That is, channel characteristics in the edge region of the channel region are maintained, and an effective length of the channel region is maintained to be substantially the same as the length of the channel region.

### BRIEF DESCRIPTION OF THE DRAWINGS

FIG. 1 is a block diagram of a display device according to an embodiment of the inventive concept;
FIG. 2 is an equivalent circuit diagram of a pixel according to an embodiment of the inventive concept;
FIG. 3 is a waveform diagram of driving signals for driving a pixel illustrated in FIG. 2;
FIG. 4 is a cross-sectional view of a display panel according to an embodiment of the inventive concept;
FIG. 5 is a graph in which the voltage-current characteristics of an oxide transistor and a silicon transistor are compared;
FIG. 6 is an enlarged cross-sectional view of a first transistor according to an embodiment of the inventive concept;
FIG. 7 is a graph in which the voltage-current characteristics of an oxide transistor according to an embodiment of the inventive concept and an oxide transistor according to a comparative example are compared;
FIGS. 8A to 8F are cross-sectional views illustrating manufacturing processes of a display panel according to an embodiment of the inventive concept;
FIG. 9 is an enlarged cross-sectional view of a first transistor according to an embodiment of the inventive concept;
FIG. 10 is an enlarged cross-sectional view of a first transistor according to an embodiment of the inventive concept; and
FIGS. 11A to 11F are cross-sectional views illustrating manufacturing processes of a display panel according to an embodiment of the inventive concept.

### MODE FOR CARRYING OUT THE INVENTION

In this specification, when a component (or region, layer, portion, etc.) is referred to as "on", "connected", or "coupled" to another component, it means that it is placed/connected/coupled directly on the other component or a third component can be disposed between them.

The same reference numerals or symbols refer to the same elements. In addition, in the drawings, thicknesses, ratios, and dimensions of components are exaggerated for effective description of technical content. "And/or" includes all combinations of one or more that the associated elements may define.

Terms such as first and second may be used to describe various components, but the components should not be limited by the terms. These terms are only used for the purpose of distinguishing one component from other components. For example, without departing from the scope of the present invention, a first component may be referred to as a second component, and similarly, a second component may be referred to as a first component. Singular expressions include plural expressions unless the context clearly indicates otherwise.

In addition, terms such as "below", "lower", "above", and "upper" are used to describe the relationship between components shown in the drawings. The terms are relative concepts and are described based on the directions indicated in the drawings.

Terms such as "include" or "have" are intended to designate the presence of a feature, number, step, action, component, part, or combination thereof described in the specification, and it should be understood that it does not preclude the possibility of presence or addition of one or more other features, numbers, steps, operations, components, parts, or combinations thereof.

Unless otherwise defined, all terms (including technical and scientific terms) used in this specification have the same meaning as commonly understood by one of ordinary skill in the art to which this invention belongs. In addition, terms such as terms defined in commonly used dictionaries should be interpreted as having a meaning consistent with the meaning having in the context of the related technology, and should not be interpreted as too ideal or too formal unless explicitly defined here.

Hereinafter, embodiments of the inventive concept will be described with reference to the drawings.

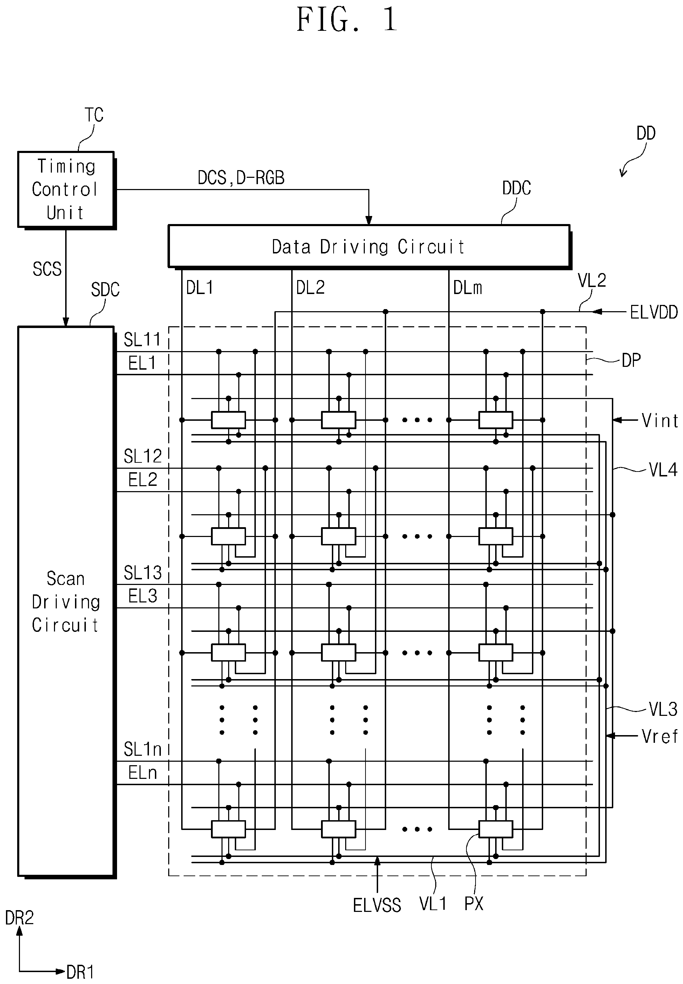

FIG. 1 is a block diagram of a display device DD according to an embodiment of the inventive concept. The display device DD includes a timing control unit TC, a scan driving circuit SDC, a data driving circuit DDC, and a display panel DP. In the present embodiment, the display panel DP is described as a light-emitting display panel. The light-emitting display panel may include an organic light-emitting display panel or an inorganic light-emitting display panel.

The timing control unit TC receives input video signals, and converts a data format of the input video signals to meet the specification of an interface with the scan driving circuit SDC to generate video data D-RGB. The timing control unit TC outputs the video data D-RGB and various control signals DCS and SCS.

The scan driving circuit SDC receives the scan control signal SCS from the timing control unit TC. The scan control signal SCS may include a vertical initiation signal for initiating an operation of the scan driving circuit SDC, and a clock signal for determining output timings of signals, etc. The scan driving circuit SDC generates a plurality of scan signals, and sequentially outputs the plurality of scan signals to corresponding scan signal lines SL11 to SL1n. In addition, the scan driving circuit SDC generates a plurality of light-emitting control signals in response to the scan control signal SCS, and outputs the plurality of light-emitting control signals to corresponding light-emitting signal lines EL1 to ELn.

FIG. 1 illustrates that the plurality of scan signals and the plurality of light-emitting control signals are output from one scan driving circuit SDC, but the inventive concept is not limited thereto. In an embodiment of the inventive concept, the display device DD may include a plurality of scan driving circuits. In addition, in an embodiment of the inventive concept, a driving circuit, which generates and outputs the plurality of scan signals, and a driving circuit, which generates and outputs the plurality of light-emitting control signals, may be separately formed.

The data driving circuit DDC receives, from the timing control unit TC, the data control signal DCS and the video data D-RGB. The data driving circuit DDC converts the video data D-RGB to data signals, and outputs the data signals to a plurality of data lines DL1 to DLm to be described later. The data signals are analog voltages corresponding to gradation values of the video data D-RGB.

The light-emitting display panel DP may include a plurality of groups of scan lines. FIG. 1 illustrates, as an example, a first group of scan signal lines SL11 to SL1n. The light-emitting display panel DP includes light-emitting signal lines EL1 to ELn, data lines DL1 to DLm, a first voltage line VL1, a second voltage line VL2, a third voltage line VL3, a fourth voltage line VL4, and a plurality of pixels PX.

The first group of scan signal lines SL11 to SL1n may extend in a first direction DR1, and may be arranged in a second direction DR2. The data lines DL1 to DLm may cross the first group of scan signal lines SL11 to SL1n.

The first voltage line VL1 receives a first power supply voltage ELVSS. The second voltage line VL2 receives a second power supply voltage ELVDD. The second power supply voltage ELVDD has a higher level than the first power supply voltage ELVSS. The third voltage line VL3 receives a reference voltage Vref (hereinafter, a first voltage). The fourth voltage line VL4 receives an initialization voltage Vint (hereinafter, a second voltage). The first voltage Vref has a lower level than the second power supply voltage ELVDD. The second voltage Vint has a lower level than the second power supply voltage ELVDD. In the present embodiment, the second voltage Vint may have a lower level than the first voltage Vref and the first power supply voltage ELVSS.

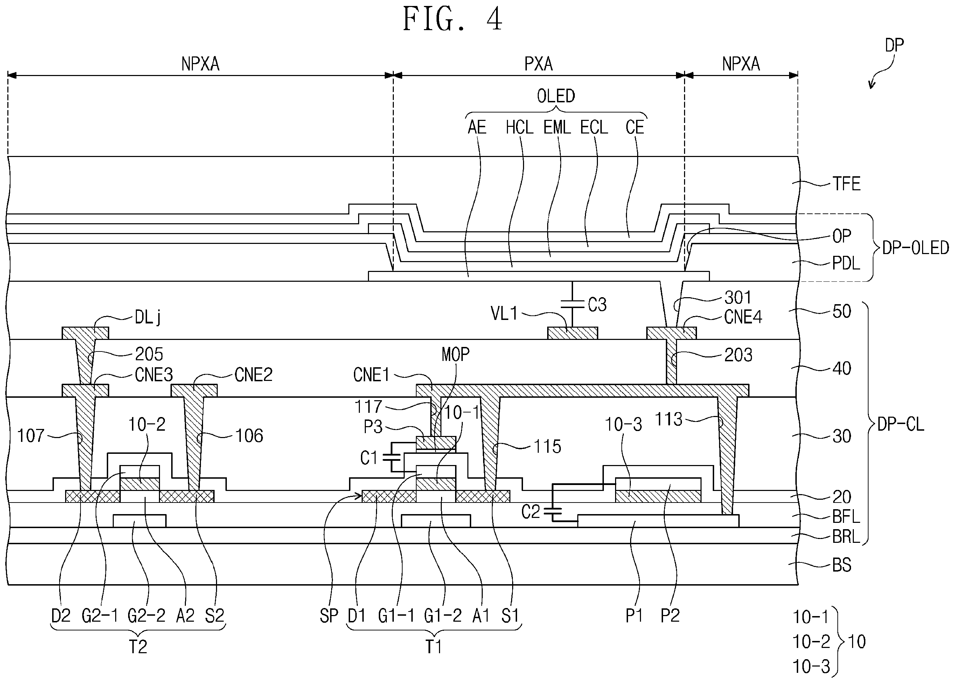

At least one of the first voltage line VL1, the second voltage line VL2, the third voltage line VL3, or the fourth voltage line VL4 may include at least one of a line extending in the first direction DR1 or a line extending in the second direction DR2. Among the voltage lines, the line extending in the first direction DR1 and the line extending in the second direction DR2 may be electrically connected to each other, although disposed on different layers of a plurality of insulating layers 10 to 40 illustrated in FIG. 4.

In the above, the display device DD according to an embodiment is described with reference to FIG. 1, but the display device DD according to the inventive concept is not limited thereto. Signal lines may be added or omitted depending on the configuration of a pixel circuit. In addition, electrical connection relationship between one pixel PX and signal lines may be changed.

A plurality of pixels PX may include a plurality of groups that generate colors different from each other. For example, the plurality of pixels PX may include red pixels that generate a red color, green pixels that generate a green color, and blue pixels that generate a blue color. A light-emitting element of a red pixel, a light-emitting element of a green pixel, and a light-emitting element of a blue pixel may include light-emitting layers of materials different from each other.

The pixel circuit may include a plurality of transistors and at least one capacitor. At least one of the scan driving circuit SDC or the data driving circuit DDC may include a plurality of transistors formed through the same process as a process for manufacturing the pixel circuit.

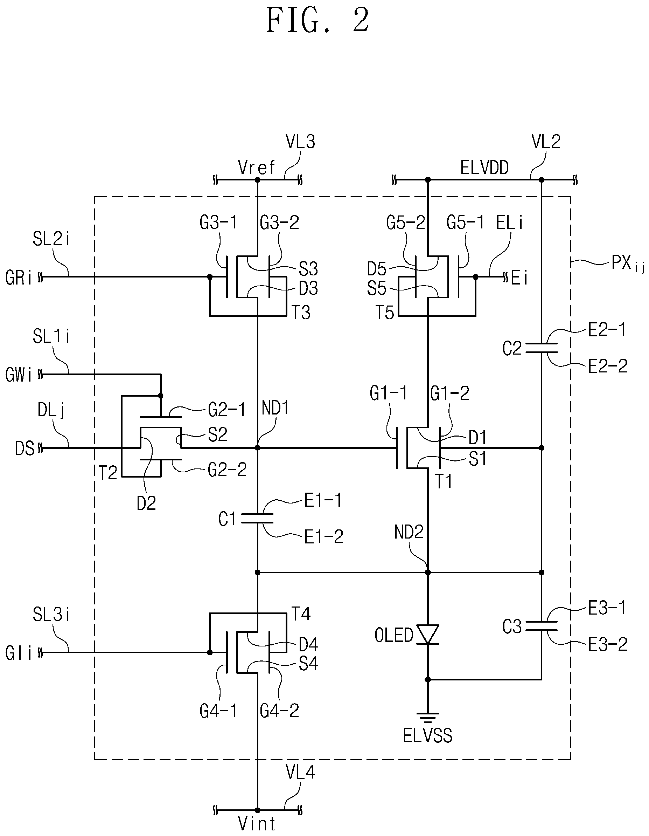

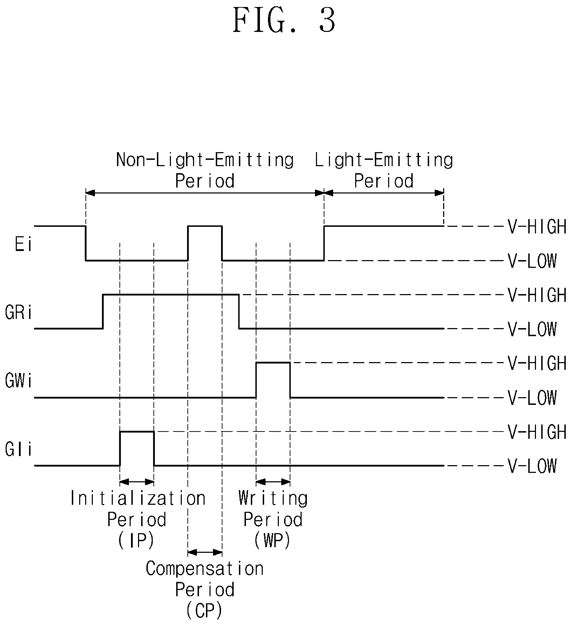

FIG. 2 is an equivalent circuit diagram of a pixel PXij according to an embodiment of the inventive concept. FIG. 3 is a waveform diagram of driving signals for driving the pixel PXij illustrated in FIG. 2.

FIG. 2 representatively illustrates the pixel PXij connected to an i-th scan line SL1i in a first group of scan lines SL11 to SL1n (see FIG. 1), and connected to a j-th data line DLj in a plurality of data lines DL1 to DLm (see FIG. 1). The pixel PXij is connected to an i-th scan line SL2i in a second group of scan lines, and is connected to an i-th scan line SL3i in a third group.

In the present embodiment, a pixel circuit may include first to fifth transistors T1 to T5, first to third capacitors C1 to C3, and a light-emitting element OLED. In the present embodiment, the first to fifth transistors T1 to T5 will be described as N-type transistors. However, an embodiment of the inventive concept is not limited thereto, and at least one of the first to fifth transistors T1 to T5 may be a P-type transistor. In addition, in an embodiment of the inventive concept, at least one of the first to fifth transistors T1 to T5 may be omitted, or an additional transistor may be further included in the pixel PXij.

In the present embodiment, it is illustrated that the first to fifth transistors T1 to T5 each include two gates, but at least one transistor may include only one gate. It is illustrated that upper gates G2-1, G3-1, G4-1, and G5-1 and lower gates G2-2, G3-2, G4-2, and G5-2 of each of second to fifth transistors T2 to T5 are electrically connected to each other, but an embodiment of the inventive concept is not limited thereto. The lower gates G2-2, G3-2, G4-2, and G5-2 of each of the second to fifth transistors T2 to T5 may be floating electrodes.

In the present embodiment, a first transistor T1 may be a driving transistor, and a second transistor T2 may be a switching transistor. A node to which a gate G1-1 (hereinafter, a first upper gate) of the first transistor T1 is connected may be defined as a first node ND1, and a node to which a first source S1 of the first transistor T1 is connected may be defined as a second node ND2.

The light-emitting element OLED includes a first electrode electrically connected to the first node ND1, a second electrode that receives a first power supply voltage ELVSS, and a light-emitting layer disposed between the first electrode and the second electrode. Detailed description of the light-emitting element OLED will be made later.

The first transistor T1 is electrically connected between the second node ND2 and the second voltage line VL2 through which the second power supply voltage ELVDD is received. The first transistor T1 may include a source S1 (hereinafter, a first source) connected to the second node ND2, a drain D1 (hereinafter, a first drain), a channel region (or semiconductor region), and the first upper gate G1-1. The first transistor T1 may further include a gate G1-2 (hereinafter, a first lower gate) connected to the second node ND2. The first transistor T1 controls a driving current of the light-emitting element OLED on the basis of a charged capacitance of the first capacitor C1.

The second transistor T2 is electrically connected between the first data line DLj and the first node ND1. The second transistor T2 may include a source S2 (hereinafter, a second source) connected to the first node ND1, a drain D2 (hereinafter, a second drain) connected to the first data line DLj, a channel region, and a gate G2-1 (hereinafter, a second upper gate) connected to the i-th scan line SL1i in the first group. The second transistor T2 may further include a gate G2-2 (hereinafter, a second lower gate) electrically connected to the second upper gate G2-1. Third to fifth transistors T3 to T5 to be described later may include upper gates G3-1, G4-1, and G5-1 and lower gates G3-2, G4-2, and G5-2 respectively corresponding to the second upper gate G2-1 and the second lower gate G2-2. The second transistor T2 provides the first capacitor C1 with a data voltage.

The third transistor T3 is electrically connected between the first node ND1 and the third voltage line VL3 through which the first voltage Vref is received. The third transistor T3 may include a drain D3 (hereinafter, a third drain) connected to the first node ND1, a source S3 (hereinafter, a third source) connected to the third voltage line VL3, a channel region, and a third upper gate G3-1 connected to the i-th scan line SL2i in the second group.

The fourth transistor T4 is electrically connected between the second node ND2 and the fourth voltage line VL4 through which the second voltage Vint is received. The fourth transistor T4 may include a drain D4 (hereinafter, a fourth drain) connected to the second node ND2, a source S4 (hereinafter, a fourth source) connected to the fourth voltage line VL4, a channel region, and a fourth upper gate G4-1 connected to the i-th scan line SL3i in the third group.

The fifth transistor T5 is electrically connected between the second voltage line VL2 and the first drain D1 or the first source S1. In the present embodiment, the fifth transistor T5 may include a drain D5 (hereinafter, a fifth drain) connected to the first drain D1, a source S5 (hereinafter, a fifth source) connected to the second voltage line VL2, a channel region, and a fifth upper gate G5-1 connected to the i-th light-emitting signal line ELi.

The first capacitor C1 is electrically connected between the first node ND1 and the second node ND2. The first capacitor C1 includes a first electrode E1-1 connected to the first node ND1 and a second electrode E1-2 connected to the second node ND2.

The second capacitor C2 is electrically connected between the second voltage line VL2 and the second node ND2. The second capacitor C2 includes a first electrode E2-1 connected to the second voltage line VL2 and a second electrode E2-2 connected to the second node ND2.

The third capacitor C3 is electrically connected between a first electrode and a second electrode of the light-emitting element OLED. The third capacitor C3 includes a first electrode E3-1 connected to the first electrode of the light-emitting element OLED and a second electrode E3-2 connected to the second electrode of the light-emitting element OLED.

An operation of the pixel PXij will be described in more detail with reference to FIGS. 2 and 3. The display device DD (see FIG. 1) displays a video in every frame period. Respective signal lines of a first group of scan lines, a second group of scan lines, a third group of scan lines, and light-emitting signal lines are sequentially scanned during a frame period. FIG. 3 illustrates a part of the frame period.

Referring to FIG. 3, signals Ei, GRi, GWi, and GIi may each have a high level V-HIGH during a partial period, and have a low level V-LOW during the other partial period. N-typed first to fifth transistors T1 to T5 described above are turned-on when control signals corresponding thereto have high levels V-HIGH.

The non-emission section may include an initialization period IP, a compensation period CP, and a writing period WP. During the initialization period IP, the third transistor T3 and the fourth transistor T4 are turned-on. The first node ND1 is initialized to the first voltage Vref. The second node ND2 is initialized to the second voltage Vint. The first capacitor C1 is initialized to a difference value between the first voltage Vref and the second voltage Vint. The second capacitor C2 is initialized to a difference value between the second power supply voltage ELVDD and the second voltage Vint. The third capacitor C3 is initialized to a difference value between the first power supply voltage ELVSS and the second voltage Vint.

During the compensation period CP, the third transistor T3 and the fifth transistor T5 are turned-on. The first capacitor C1 is compensated by a voltage corresponding to a threshold voltage of the first transistor T1.

During the writing period WP, the second transistor T2 is turned-on. The second transistor T2 outputs a voltage (or data voltage) corresponding to a data signal DS. As a result, a voltage level corresponding to the data signal DS is charged in the first capacitor C1. The data signal DS, in which the threshold voltage of the first transistor T1 is compensated, is charged in the first capacitor C1. Threshold voltages of driving transistors may be different from each other in each pixel PX (see FIG. 1), the pixel PXij illustrated in FIGS. 2 and 3 may supply, to the light-emitting element OLED, a current with a magnitude proportional to the data signal DS regardless of the deviation between the threshold voltages of the driving transistors.

Thereafter, during a light-emitting period, the fifth transistor T5 is turned-on. The first transistor T1 supplies, to the light-emitting element OLED, a current corresponding to a stored charged capacitance of the capacitor C1. The light-emitting element OLED may emit light having luminance corresponding to the data signal DS.

FIG. 4 is a cross-sectional view of a display panel DP according to an embodiment of the inventive concept. FIG. 4 illustrates a cross-section of a part corresponding to a partial configuration in a pixel PXij illustrated in FIG. 2.

Referring to FIG. 4, the display panel DP may include a base layer BS, a circuit element layer DP-CL disposed on the base layer BS, a display element layer DP-OLED, and a thin film encapsulation layer TFE. The display panel DP may further include functional layers such as an anti-reflective layer or a refractive index control layer. The circuit element layer DP-CL includes at least a plurality of insulating layers and a circuit element. Insulating layers to be described later may include an organic layer and/or an inorganic layer.

An insulating layer, a semiconductor layer, and a conductive layer are formed through a process such as coating and deposition. Thereafter, the insulating layer, the semiconductor layer, and the conductive layer may be selectively patterned through photolithography and etching processes. A semiconductor pattern, a conductive pattern, a signal line, etc., are formed through such processes. Patterns disposed on the same layer are formed through the same process.

The base layer BS may include a synthetic resin film. A synthetic resin layer may include a thermosetting resin. Particularly, the synthetic resin layer may be a polyimide-based resin layer, and is not limited to a specific material. The synthetic resin layer may include at least one of an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, or a perylene-based resin. In addition, the base layer may include a glass substrate, a metal substrate, an organic/inorganic composite substrate, or the like. The base layer may include a first polyimide layer, a second polyimide layer, and an inorganic layer disposed therebetween.

At least one inorganic layer is formed on an upper surface of the base layer BS. The inorganic layer may include at least one of aluminium oxide, titanium oxide, silicon oxide, silicon nitride, silicon oxynitride, zirconium oxide, or hafnium oxide. The inorganic layer may have a multilayer structure. Multilayered inorganic layers may constitute a barrier layer BRL and/or a buffer layer BFL to be described later. The barrier layer BRL and the buffer layer BFL may be selectively disposed.

The barrier layer BRL prevents foreign matters from being introduced from the outside. The barrier layer BRL may include a silicon oxide layer and a silicon nitride layer. The silicon oxide layer and the silicon nitride layer may be each provided in plurality, and may be alternately stacked.

A conductive layer (hereinafter, a first conductive layer) is disposed on the barrier layer BRL. The first conductive layer may include a plurality of conductive patterns. FIG. 4 illustrates a partial pattern of the first conductive pattern. A first lower gate G1-2, a second lower gate G2-2, and a first conductive pattern P1 are illustrated as an example of the conductive patterns of the first conductive layer.

The first conductive pattern P1 defines the second electrode E2-2 of the second capacitor C2 illustrated in FIG. 2. The first lower gate G1-2 and the first conductive pattern P1 are illustrated in FIG. 4 as being spaced apart from each other, but may be electrically connected to each other. The first lower gate G1-2 and the first conductive pattern P1 may be connected to each other through a conductive pattern disposed on a layer different from a layer on which the first lower gate G1-2 and the first conductive pattern P1 are disposed. Alternatively, the first lower gate G1-2 and the first conductive pattern P1 may have an integrated shape on a plane.

The buffer layer BFL may be disposed on the barrier layer BRL to cover the first lower gate G1-2, the second lower gate G2-2, and the first conductive pattern P1. The buffer layer BFL improves a binding force between the base layer BS and a semiconductor pattern and/or a conductive pattern. The buffer layer BFL may include a silicon oxide layer and a silicon nitride layer. The silicon oxide layer and the silicon nitride layer may be alternately stacked.

A semiconductor layer is disposed on the buffer layer BFL. The semiconductor layer may include a plurality of semiconductor patterns. In the present embodiment, the semiconductor pattern may be a metal oxide semiconductor pattern SP. The metal oxide semiconductor pattern SP may include a crystalline or amorphous oxide semiconductor. For example, the metal oxide semiconductor pattern SP may include: an oxide of metal such as zinc (Zn), indium (In), gallium (Ga), tin (Sn), titanium (Ti); or a mixture of metal such as zinc (Zn), indium (In), gallium (Ga), tin (Sn), titanium (Ti), and an oxide thereof. An oxide semiconductor may include indium-tin oxide (ITO), indium-gallium-zinc oxide (IGZO), zinc oxide (ZnO), indium-zinc oxide (IZnO), zinc-gallium oxide (ZIO), indium oxide (InO), titanium oxide (TiO), indium-zinc-tin oxide (IZTO), zinc-tin oxide (ZTO), or the like.

The metal oxide semiconductor pattern SP may include a plurality of regions divided depending on whether or not the metal oxide is reduced. A region (hereinafter, a reduced region) in which the metal oxide is reduced has a greater conductivity than a region (hereinafter, a non-reduced region) in which the metal oxide is not reduced. The reduced region substantially serves as a source region, a drain region, or a signal delivery region of a transistor. The non-reduced region substantially corresponds to a channel region (or semiconductor region, or non-reduced region) of a transistor. In other words, one part of a semiconductor pattern may be a channel region of a transistor, another part may be a source region or a drain region of the transistor, and still another part may be a signal delivery region.

Substantially, a first upper gate G1-1 to be described later defines a channel region A1 of the first transistor T1, and a second upper gate G2-1 to be described later defines a channel region A2 of the second transistor T2. The length of the channel region A1 of the first transistor T1 may be determined to correspond to the width of the first upper gate G1-1, and the length of the channel region A2 of the second transistor T2 may be determined to correspond to the width of the second upper gate G2-1.

A source region or a drain region itself may be a source or a drain of each of transistors T1 to T5 described in FIG. 2. The source or the drain of each of the transistors T1 to T5 may include the source region or the drain region of the semiconductor pattern described above and a conductive pattern connected thereto. Hereinafter, the source region or drain region of the metal oxide semiconductor pattern SP is referred to as a source or drain for convenience of explanation.

As illustrated in FIG. 4, the first transistor T1 includes the metal oxide semiconductor pattern SP including a source S1, a channel region A1, and a drain D1. The source S1 and the drain D1 of the first transistor T1 extends from the channel region A1 in directions opposite to each other. A source S2, a channel region A2, and a drain D2 of the second transistor T2 are also formed from a semiconductor pattern.

The first lower gate G1-2 and the second lower gate G2-2 described above serve as a light-blocking pattern. The first lower gate G1-2 and the second lower gate G2-2 are respectively disposed under the channel region A1 of the first transistor T1 and the channel region A2 of the second transistor T2 to block light incident from the outside. The first lower gate G1-2 and the second lower gate G2-2 prevent external light from changing the voltage-current characteristics of each of the first transistor T1 and the second transistor T2.

A first insulating layer 10 is disposed on the buffer layer BFL. In the present embodiment, the first insulating layer 10 is not entirely formed on the display panel DP, and overlaps only on a channel region of a transistor, or a specific conductive pattern to be described later. The first insulating layer 10 includes a plurality of insulating patterns. FIG. 4 illustrates, as an example, a first insulating pattern 10-1, a second insulating pattern 10-2, and a third insulating pattern 10-3. In an embodiment of the inventive concept, the first insulating layer 10 may not be patterned. In this case, the first insulating layer 10 may cover the metal oxide semiconductor pattern SP.

The first insulating pattern 10-1 and the second insulating pattern 10-2 respectively overlap the first upper gate G1-1 and the second upper gate G2-1 to be described later. The third insulating pattern 10-3 overlaps a second conductive pattern P2 to be described later.

A conductive layer (hereinafter, a second conductive layer) is disposed on the first insulating layer 10. The second conductive layer may include a plurality of conductive patterns each overlapping the first insulating layer 10. FIG. 4 illustrates the first upper gate G1-1, the second upper gate G2-1, and the second conductive pattern P2 as an example of conductive patterns of the second conductive layer. Since the second conductive layer and the first insulating layer 10 are etched through the same process, the conductive patterns of the second conductive layer and the insulating patterns of the first insulating layer 10 may substantially have the same shape. An edge of the conductive pattern of the second conductive layer and an edge of the insulating pattern of the first insulating layer 10 overlapping each other are aligned. The first upper gate G1-1 may define the first electrode E1-1 of the first capacitor C1 illustrated in FIG. 2. The first upper gate G1-1 may extend from the first electrode E1-1 of the first capacitor C1 on a plane, and thus the first upper gate G1-1 may be defined as a part of the first electrode E1-1 of the first capacitor C1.

The second conductive pattern P2 defines the first electrode E2-1 of the second capacitor C2 illustrated in FIG. 2. Although not illustrated, the second conductive pattern P2 may be electrically connected to the second voltage line VL2.

A second insulating layer 20, which covers the first upper gate G1-1, the second upper gate G2-1, and the second conductive pattern P2, is disposed on the buffer layer BFL. The second insulating layer 20 may be an inorganic layer and/or an organic layer, and may have a single- or multi-layered structure. The second insulating layer 20 may cover the source S1 and the drain D1 of the first transistor T1, and the source S2 and the drain D2 of the second transistor T2. The second insulating layer 20 may cover side surfaces of each of the first insulating pattern 10-1, the second insulating pattern 10-2, and the third insulating pattern 10-3.

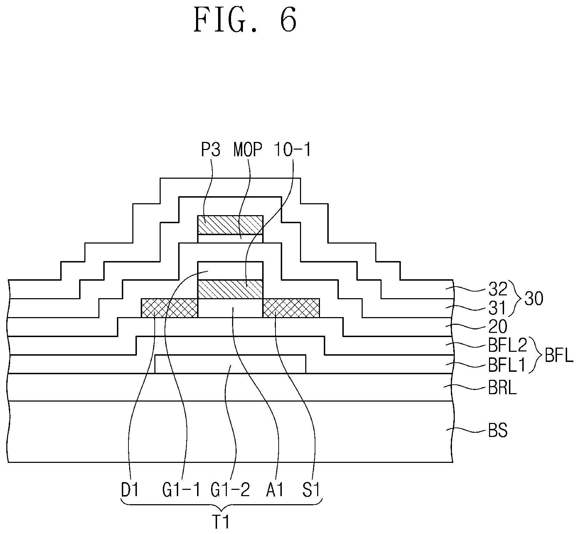

A metal oxide pattern MOP may be disposed on the second insulating layer 20. Detailed description thereof will be made later with reference to FIG. 6.

A conductive layer (hereinafter, a third conductive layer) is disposed on the second insulating layer 20. The third conductive layer may include a plurality of conductive patterns overlapping the second insulating layer 20. The third conductive layer may include a third conductive pattern P3 overlapping the first upper gate G1-1. The third conductive pattern P3 defines the second electrode E1-2 of the first capacitor C1 illustrated in FIG. 2. The third conductive pattern P3 may extend from the second electrode E1-2 of the first capacitor C1 on a plane, and thus the third conductive pattern P3 may be defined as a part of the second electrode E1-2 of the first capacitor C1.

In an embodiment of the inventive concept, although the third conductive layer includes a conductive pattern, the third conductive pattern P3 overlapping the first upper gate G1-1 may be omitted. That is, the second electrode E1-2 of the first capacitor C1 may not overlap the first upper gate G1-1.

A third insulating layer 30 covering the third conductive pattern P3 is disposed on the second insulating layer 20. In the present embodiment, the third insulating layer 30 may be an inorganic layer and/or an organic layer, and may have a single- or multi-layered structure.

A conductive layer (hereinafter, a fourth conductive layer) is disposed on the third insulating layer 30. The fourth conductive layer may include a plurality of conductive patterns. The fourth conductive layer may include a plurality of connection electrodes. FIG. 4 exemplarily illustrates first to third connection electrodes CNE1 to CNE3. The first connection electrode CNE1 may be connected to the first conductive pattern P1 through a contact hole 113 penetrating the buffer layer BFL, and the second and third insulating layers 20 and 30, may be connected to the first source S1 through a contact hole 115 penetrating the second and third insulating layers 20 and 30, and may be connected to the third conductive pattern P3 through a contact hole 117 penetrating the third insulating layer 30. The second connection electrode CNE2 is connected to the second source S2 through a contact hole 106 penetrating the second and third insulating layers 20 and 30, and the third connection electrode CNE3 is connected to the second drain D2 through a contact hole 107 penetrating the second and third insulating layers 20 and 30.

A fourth insulating layer 40 covering the fourth conductive layer is disposed on the third insulating layer 30. In the present embodiment, the fourth insulating layer 40 may be an organic layer, and may have a single-layered structure, but an embodiment of the inventive concept is not limited thereto.

A conductive layer (hereinafter, a fifth conductive layer) is disposed on the fourth insulating layer 40. The fifth conductive layer may include a plurality of conductive patterns. The fifth conductive layer includes a fourth connection electrode CNE4. The fourth connection electrode CNE4 is connected to the first connection electrode CNE1 through a contact hole 203 penetrating the fourth insulating layer 40.

The fifth conductive layer may further include a data line DLj and a first voltage line VL1. The data line DLj may be connected to the third connection electrode CNE3 through a contact hole 205 penetrating the fourth insulating layer 40. A part of the first voltage line VL1 overlapping the first electrode AE of the light-emitting element OLED to be described later defines the second electrode E3-2 of the third capacitor C3 illustrated in FIG. 2. A part of the first electrode AE of the light-emitting element OLED defines the first electrode E3-1 of the third capacitor C3 illustrated in FIG. 2.

A fifth insulating layer 50, which covers the fourth conductive layer, is disposed on the fourth insulating layer 40. In the present embodiment, the fifth insulating layer 50 may be an organic layer, and may have a single-layered structure, but an embodiment of the inventive concept is not specially limited thereto.

The first electrode AE of the light-emitting element OLED is disposed on the fifth insulating layer 50. The first electrode AE may be an anode. A pixel-defining film PDL is disposed on the fifth insulating layer 50. The first electrode AE is connected to a fourth connection electrode CNE4 through a contact hole 301 penetrating the fifth insulating layer 50.

An opening OP of the pixel-defining film PDL exposes at least a part of the first electrode AE. The opening OP of the pixel-defining film PDL may define a light-emitting region PXA. For example, a plurality of pixels PX (see FIG. 1) may be disposed according to a predetermined rule on a plane of the display panel DP (see FIG. 1). A region in which the plurality of pixels PX are disposed may be defined as a pixel region, and one pixel region may include a light-emitting region PXA and a non-light-emitting region NPXA adjacent to the light-emitting region PXA. The non-light-emitting region NPXA may surround the light-emitting region PXA.

A hole control layer HCL may be disposed, in common, on the light-emitting region PXA and the non-light-emitting region NPXA. A common layer such as the hole control layer HCL may be formed, in common, on the plurality of pixels PX. The hole control layer HCL may include a hole transport layer and a hole injection layer.

A light-emitting layer EML is disposed on the hole control layer HCL. The light-emitting layer EML may be disposed only in a region corresponding to the opening OP. The light-emitting layer EML may be separately formed in each of the plurality of pixels PX.

In the present embodiment, a patterned light-emitting layer EML is illustrated as an example, but the light-emitting layer EML may be disposed, in common, on the plurality of pixels PX. The light-emitting layer EML disposed in common may generate white light or blue light. In addition, the light-emitting layer EML may have a multi-layered structure.

An electron control layer ECL is disposed on the light-emitting layer EML. The electron control layer ECL may include an electron transport layer and an electron injection layer. A second electrode CE is disposed on the electron control layer ECL. The electron control layer ECL and the second electrode CE are disposed, in common, on the plurality of pixels PX.

A thin film encapsulation layer TFE is disposed on the second electrode CE. The thin film encapsulation layer TFE is disposed, in common, on the plurality of pixels PX. In the present embodiment, the thin film encapsulation layer TFE directly covers the second electrode CE. In an embodiment of the inventive concept, a capping layer directly covering the second electrode CE may be further disposed. In an embodiment of the inventive concept, the stack structure of the light-emitting element OLED may have a structure in which the structure shown in FIG. 4 is upside down.

The thin film encapsulation layer TFE includes at least an inorganic layer or an organic layer. In an embodiment of the inventive concept, the thin film encapsulation layer TFE may include two inorganic layers and an organic layer disposed therebetween. In an embodiment of the inventive concept, the thin film encapsulation layer may include a plurality of inorganic layers and a plurality of organic layers which are alternately stacked.

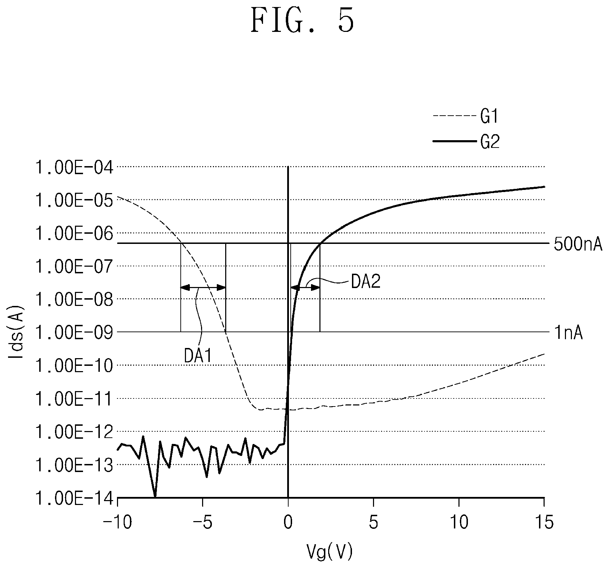

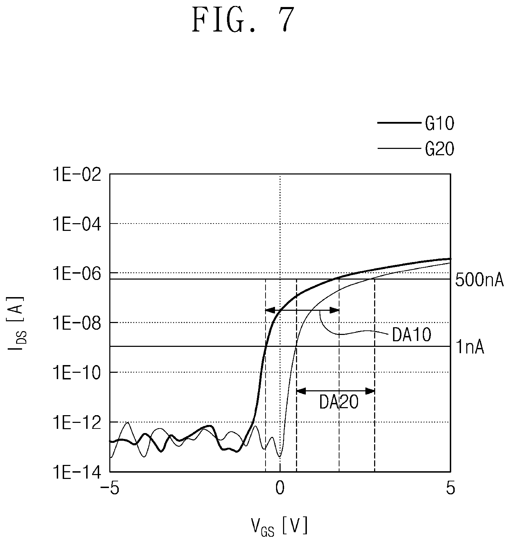

FIG. 5 is a graph in which the voltage-current characteristics of an oxide transistor and a silicon transistor are compared. FIG. 6 is an enlarged cross-sectional view of a first transistor T1 according to an embodiment of the inventive concept. FIG. 7 is a graph in which the voltage-current characteristics of an oxide transistor according to an embodiment of the inventive concept and an oxide transistor according to a comparative example are compared.

A first graph G1 in FIG. 5 shows the voltage-current characteristics of a P-type silicon transistor. A second graph G2 shows the voltage-current characteristics of an N-type oxide transistor. According to the first graph G1 and the second graph G2, it may be seen that a gate voltage (Vg) range DA2 (hereinafter, a driving voltage range) of an oxide transistor having a driving current (Ids) of about 1 nA to about 500 nA is narrower than a gate voltage (Vg) range DA1 of a silicon transistor having a driving current (Ids) of about 1 nA to about 500 nA. When the driving voltage range is narrow, there may be a limitation in that a gradation voltage needs to be finely controlled to express a plurality of gradations. Meanwhile, an oxide transistor is advantageous in having a smaller leakage current than a silicon transistor.

According to what will be described later, the first transistor T1 may have a wider driving voltage range by controlling resistances of the first source S1 and the first drain D1 of the first transistor T1. Detailed description thereof will be made with reference to FIGS. 6 and 7.

Referring to FIG. 6, a buffer layer BFL may include a silicon nitride layer BFL1 and a silicon oxide layer BFL2. A first insulating pattern 10-1 may include a silicon oxide layer. A first upper gate G1-1 and a third conductive pattern P3 may have a single- or multi-layered structure consisting of any one among molybdenum (Mo), aluminium (Al), chromium (Cr), gold (Au), titanium (Ti), nickel (Ni), neodymium (Nd), and copper (Cu), or an alloy thereof.

A second insulating layer 20 may include a silicon oxide layer or a silicon oxynitride layer. A third inorganic layer 30 may include a silicon oxynitride layer 31 and a silicon nitride layer 32 disposed on the silicon oxynitride layer 31.

According to the present embodiment, a metal oxide pattern MOP may be disposed between the third conductive pattern P3 and the second insulating layer 20. The metal oxide pattern MOP may have a thickness of about 100 Å to about 300 Å. The metal oxide pattern MOP may include: an oxide of any one among indium (In), tin (Sn), zinc (Zn), gallium (Ga), magnesium (Mg), hafnium (Hf), and titanium (Ti); or a mixture of any one metal among indium (In), tin (Sn), zinc (Zn), gallium (Ga), magnesium (Mg), hafnium (Hf), and titanium (Ti), and an oxide thereof.

The metal oxide pattern MOP may be formed through sputtering or metal organic chemical vapor deposition (MOCVD), an oxygen gas is used in such a process, during which oxygen is supplied to the second insulating layer 20 disposed thereunder. In this sense, the metal oxide pattern MOP may be defined as an oxygen supply pattern. The oxygen supplied to the second insulating layer 20 may diffuse to the lower side of the second insulating layer 20 during a subsequent heat-treatment process, and may move to an oxide semiconductor pattern. The first upper gate G1-1 may be disposed on the channel region A1, thereby blocking oxygen from diffusing toward the channel region A1. Accordingly, the oxygen supplied to the channel region A1 may be less than the oxygen supplied to the source S1 and the drain D1.

Hydrogen may be supplied to the source S1 and the drain D1 in the process of forming the second insulating layer 20 and the third inorganic layer 30. Particularly, since the process of forming the silicon nitride layer 32 maintains high hydrogen partial pressure, a large amount of hydrogen may be supplied to the oxide semiconductor pattern.

Hydrogen corresponds to a carrier, and thus reduces the resistance of the metal oxide semiconductor pattern, especially, the resistances of the source S1 and the drain D1. The first upper gate G1-1 may be disposed on the channel region A1, thereby blocking hydrogen from diffusing toward the channel region A1. Accordingly, the channel region A1 may maintain semiconductor characteristics, compared to the first source S1 and the first drain D1.

The amount of hydrogen and oxygen supplied to the source S1 and the drain D1 in the aforementioned process may determine the resistances of the source S1 and the drain D1. Oxygen supplied to the source S1 and the drain D1 may reduce oxygen deficiency in the source S1 and the drain D1, and may suppress oxygen deficiency and hydrogen bonding, thereby preventing reduction in the resistances of the source S1 and the drain D1.

In the process of forming the metal oxide pattern MOP, although the first upper gate G1-1 covers the channel region A1, oxygen may diffuse to an edge region of the channel region A1 in boundary regions between the channel region A1 and the source S1 or between the channel region A1 and the drain D1. In the aforementioned process of forming the silicon nitride layer 32 of the third insulating layer 30, although hydrogen diffuses to the edge region of the channel region A1 in the boundary region between the channel region A1 and the source S1 or between the channel region A1 and the drain D1, oxygen deficiency may be removed by oxygen that has been already supplied. Therefore, it is possible to prevent hydrogen from being bonded to the channel region A1. As a result, the effective length of the channel region A1 may be prevented from being shorter than the length of the channel region A1.

The channel region A1 may have a length of about 3 µm or less, and in this case, the channel region A1 may have short channel characteristics. By the above principle, the effective length of the channel region A1 may be maintained to be substantially the same as the length of the channel region A1 corresponding to the width of the first upper gate G1-1.

A first graph G10 in FIG. 7 shows a voltage-current curve of a transistor in which a metal oxide pattern MOP of FIG. 6 is not formed, and a second graph G20 in FIG. 7 shows a voltage-current curve of a first transistor T1 of FIG. 6. Measurement shows that a source S1 and a drain D1 of the transistor in which the metal oxide pattern MOP is not formed have a resistance of about 217.75 Ω/□(or Ω/sq), and a source S1 and a drain D1 of the transistor T1 of FIG. 6 have a resistance of about 513.32 Ω/□. Measurement shows that while the transistor in which the metal oxide pattern MOP is not formed has a driving voltage V_{GS} range DA10 of about 1.92 V, the first transistor T1 of FIG. 6 has a driving voltage V_{GS} range DA20 of about 2.1 V.

As described with reference to FIG. 6, it may be confirmed through FIG. 7 that since oxygen is injected in the process of forming the metal oxide pattern MOP, the resistances of the source S1 and the drain D1 of the first transistor T1 are increased, and the driving voltage range of the first transistor T1 becomes wider.

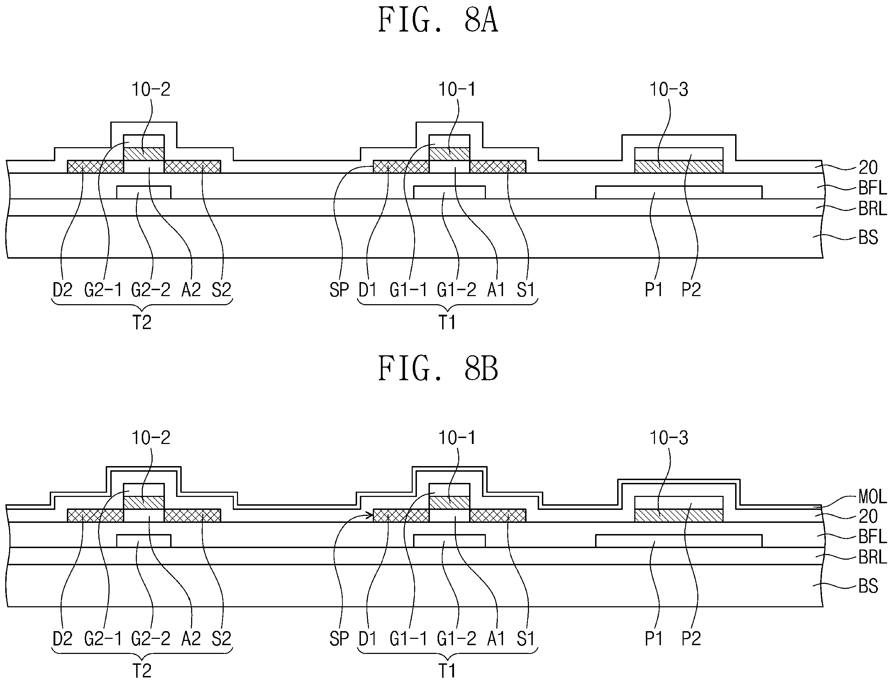

FIGS. 8A to 8F are cross-sectional views illustrating manufacturing processes of a display panel DP according to an embodiment of the inventive concept. Hereinafter, detailed description of the same configuration as a configuration described with reference to FIGS. 4 to 7 is omitted.

As illustrated in FIG. 8A, a first transistor T1 is formed on a base layer BS. As described with reference to FIG. 4, the first transistor T1 includes a first lower gate G1-2, a metal oxide semiconductor pattern SP, a first insulating pattern 10-1, and a first upper gate G1-1. A second transistor T2 may be formed through the same process as a process of forming the first transistor T1. A first conductive pattern P1 of a second capacitor C2 and the first lower gate G1-2 may be formed through the same process, and a second conductive pattern P2 of the second capacitor C2 and the first upper gate G1-1 may be formed through the same process.

A second insulating layer 20, which covers the first upper gate G1-1, a first source S1, and a first drain D1, is formed on the base layer BS. For example, an inorganic material may be deposited using plasma enhanced chemical vapor deposition (PECVD).

Thereafter, as illustrated in FIG. 8B, a metal oxide layer MOL is formed on the second insulating layer 20. The metal oxide layer MOL may be formed using sputtering or metal organic chemical vapor deposition (MOCVD). In the forming of the metal oxide layer MOL, a partial pressure of an oxygen gas with respect to a reaction gas may be about 50% to 100%. The reaction gas may further include a silane gas, a fluorosilane gas, a nitrogen dioxide gas, etc.

In the process of depositing the metal oxide layer MOL, oxygen (for example, oxygen radicals, oxygen atoms, or oxygen ions) may be supplied to the second insulating layer 20 by an oxygen plasma, and then may diffuse to the metal oxide semiconductor pattern SP through a heat-treatment process.

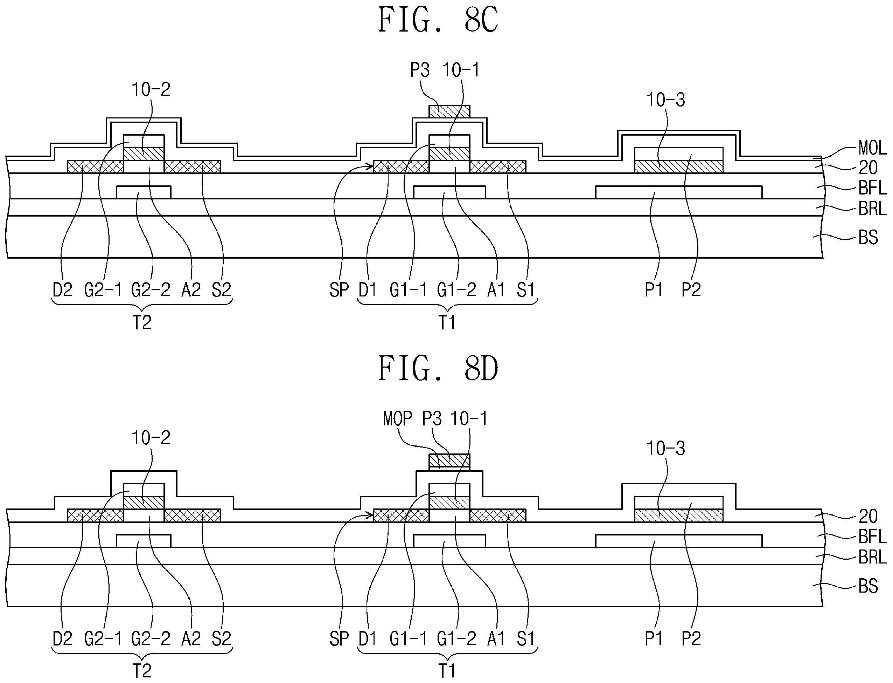

Thereafter, as illustrated in FIG. 8C, a conductive pattern P3 is formed on the metal oxide layer MOL. After forming the conductive layer, the conductive layer is patterned through a photolithography process and an etching process. In an embodiment of the inventive concept, a process of forming the third conductive pattern P3 overlapping the first upper gate G1-1 may be omitted.

Thereafter, as illustrated in FIG. 8D, the metal oxide layer MOL is patterned using the conductive pattern P3 as a mask. The metal oxide layer MOL may be patterned through a wet etching process. The metal oxide pattern MOP aligned with the conductive pattern P3 may be formed from the metal oxide layer MOL. An edge of the metal oxide pattern MOP and an edge of the conductive pattern P3 may be aligned.

When the conductive pattern P3 is not formed, the metal oxide layer MOL may be patterned using a separate mask pattern. A photoresist pattern may be used as the mask pattern.

When the conductive pattern P3 is not formed, the metal oxide layer MOL may be completely removed. Since oxygen has been already supplied to the second insulating layer 20 in the forming of the metal oxide layer MOL, the resistances of the first source S1 and the first drain D1 may be controlled, as described with reference to FIG. 6, although the metal oxide layer MOL is completely removed. Meanwhile, when the metal oxide pattern MOP remains, oxygen may additionally further diffuse from the metal oxide pattern MOP to the metal oxide semiconductor pattern SP during subsequent processes.

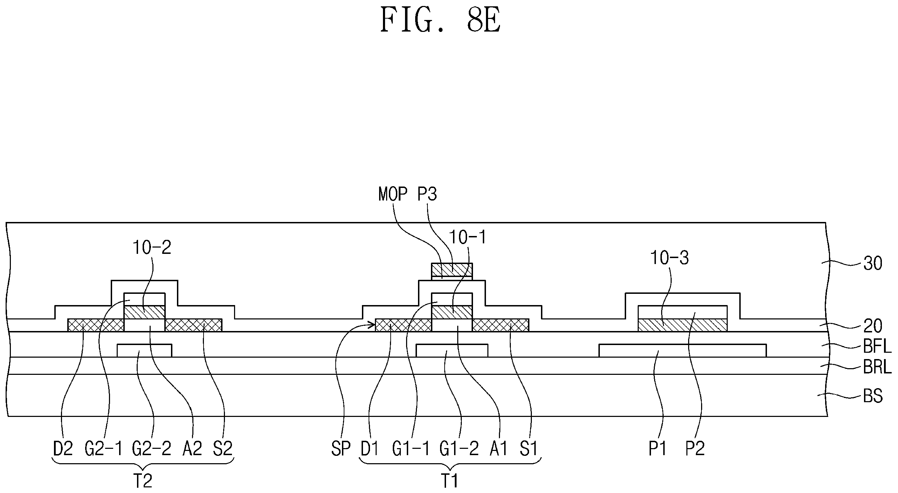

Thereafter, as illustrated in FIG. 8E, a third insulating layer 30 is formed on the second insulating layer 20. As illustrated in FIG. 6, a silicon oxynitride layer and a silicon nitride layer may be sequentially formed using plasma enhanced chemical vapor deposition (PECVD).

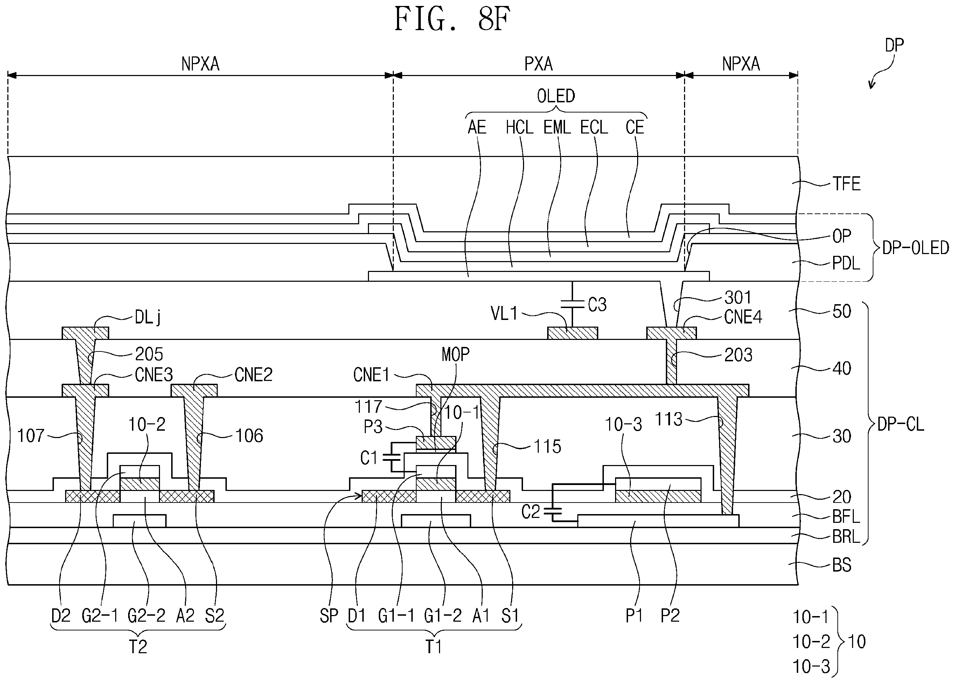

Thereafter, as illustrated in FIG. 8F, a light-emitting element OLED is formed on the third insulating layer 30. Contact holes 106, 107, 113, 115, and 117 are formed through a photolithography process and an etching process. Thereafter, first to third connection electrodes CNE1, CNE2, and CNE3 are formed by forming a metal layer and then patterning the metal layer.

Thereafter, a process of forming an insulating layer and a process of forming a conductive pattern are repeated. A fourth insulating layer 40 is formed, and a data line DLj, a first voltage line VL1, and a fourth connection electrode CNE4 are formed. A fifth insulating layer 50 is formed on the fourth insulating layer 40. Thereafter, the light-emitting element OLED is formed on the fifth insulating layer 50.

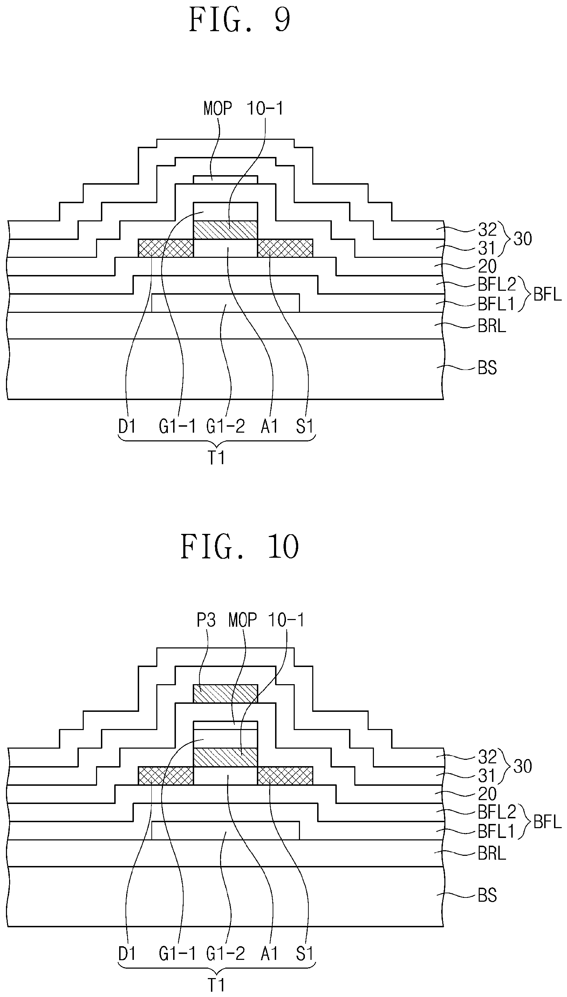

FIG. 9 is an enlarged cross-sectional view of a first transistor T1 according to an embodiment of the inventive concept. Hereinafter, detailed description of the same configuration as the first transistor T1 described with reference to FIG. 6 is omitted.

According to the present embodiment, unlike what is illustrated in FIG. 6, a third conductive pattern P3 is omitted. A metal oxide pattern MOP may be formed by patterning a metal oxide layer using an additional mask pattern.

The metal oxide pattern MOP may be a floating pattern, or may correspond to a second electrode E1-2 of a first capacitor C1, like the third conductive pattern P3. The metal oxide pattern MOP may be reduced in the process of forming the third inorganic layer 30 to have a decreased resistance, and may serve as an electrode.

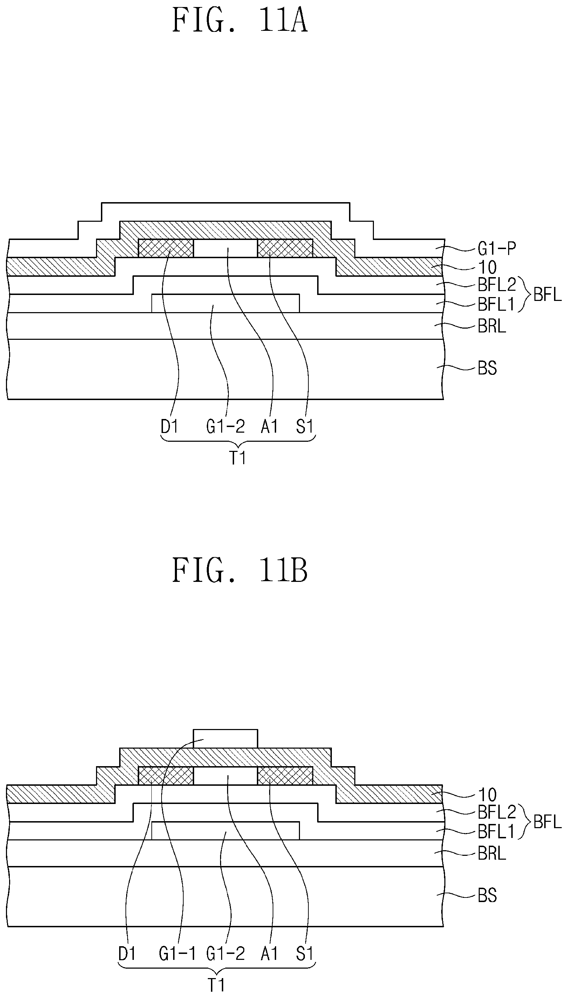

FIG. 10 is an enlarged cross-sectional view of a first transistor according to an embodiment of the inventive concept. FIGS. 11A to 11F are cross-sectional views illustrating manufacturing processes of a display panel according to an embodiment of the inventive concept. Hereinafter, detailed description of the same configuration as the first transistor T1 described with reference to FIGS. 1 to 9 is omitted.

As illustrated in FIG. 10, a metal oxide pattern MOP may be disposed on an upper surface of a first upper gate G1-1. The metal oxide pattern MOP may be in contact with the upper surface of the first upper gate G1-1. A second insulating layer 20 may cover the metal oxide pattern MOP in a region overlapping the first upper gate G1-1. A third conductive pattern P3 may be disposed on the second insulating layer 20.

As illustrated in FIG. 11A, a metal oxide semiconductor pattern SP is formed on a base layer BS. Thereafter, a first insulating layer 10 and a metal layer G1-P are formed on a buffer layer BFL.

As illustrated in FIG. 11B, a first upper gate G1-1 is formed from the metal layer G1-P through a photolithography process and an etching process.

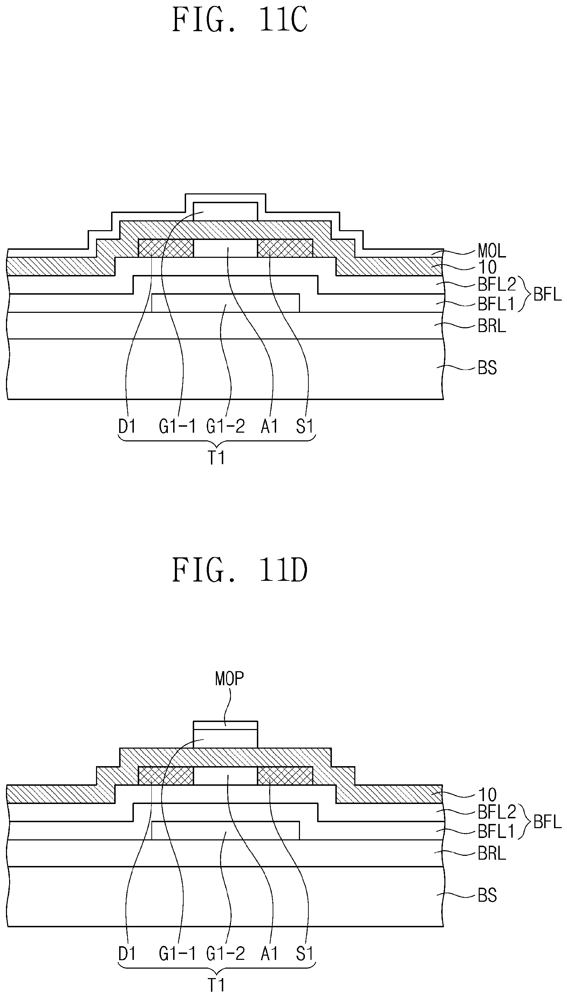

As illustrated in FIG. 11C, a metal oxide layer MOL which covers the first upper gate G1-1 is formed on the first insulating layer 10. Oxygen may be supplied to the first insulating layer 10 in the process of forming the metal oxide layer MOL, and may be injected to regions exposed from the first upper gate G1-1 of the metal oxide semiconductor pattern SP through a heat-treatment process.

As illustrated in FIG. 11D, a metal oxide pattern MOP is formed from the metal oxide layer MOL through a photolithography process and an etching process. According to an embodiment of the inventive concept, the metal oxide layer MOL may be entirely removed.

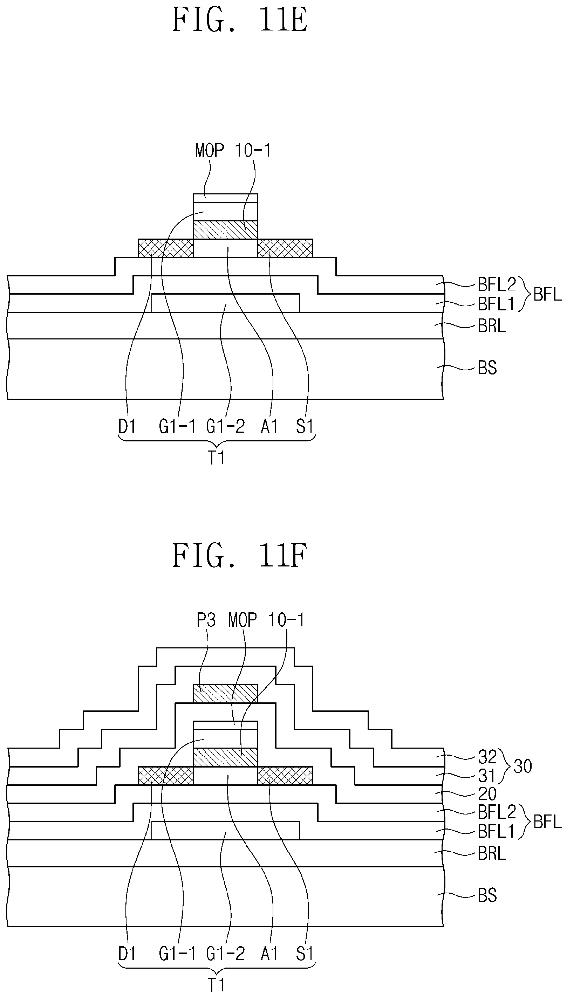

As illustrated in FIG. 11E, a first insulating pattern 10-1 is formed from the first insulating layer 10 through an etching process. In the etching process of FIG. 11E, the first upper gate G1-1 may be used as a mask. In an embodiment of the inventive concept, the process of patterning the first insulating layer 10 may be omitted. In this case, the first insulating pattern 10-1 may entirely cover the metal oxide semiconductor pattern SP.

As illustrated in FIG. 11F, a third insulating layer 30 is formed on the second insulating layer 20. A silicon oxynitride layer 31 and a silicon nitride layer 32 may be sequentially formed using plasma enhanced chemical vapor deposition (PECVD). FIGS. 11A to 11F describe manufacturing processes of a display panel while focusing on the first transistor T1, but post processes may be additionally performed. Since the post processes are the same as those described with reference to FIGS. 8E and 8F, detailed description thereof is omitted.

In the above, description has been made with reference to preferred embodiments of the inventive concept, but those skilled in the art or those of ordinary skill in the relevant technical field may understand that various modifications and changes may be made to the inventive concept within the scope not departing from the technology scope of the inventive concept described in the claims to be described later.

Therefore, the technical scope of the inventive concept is not limited to the contents described in the detailed description of the specification, but should be determined by the claims.

### INDUSTRIAL APPLICABILITY

A display device essentially includes a thin film transistor as a pixel driving circuit. Improving the performance of thin film transistors can help improve the display quality of display devices. Oxide transistors with a wider driving voltage range are likely to be applied to display devices.

## Claims

1. A display device (DD) comprising:
a plurality of insulating layers (10, 20, 30, 40);
a light-emitting element (OLED); and
a pixel circuit electrically connected to the light-emitting element (OLED),
wherein the pixel circuit comprises a first transistor (T1), and
the first transistor (T1) comprises
a metal oxide semiconductor pattern (SP) including a source region (S1), a drain region (D1) and a channel region (A1) disposed between the source region (S1) and the drain region (D1),
a first gate (G1-1) disposed on the metal oxide semiconductor pattern (SP), and overlapping the channel region (A1) on a plane, and
a metal oxide pattern disposed (MOP) on the first gate (G1-1),
wherein the plurality of insulating layers (10, 20, 30, 40) comprise a first insulating layer (10) disposed between the channel region (A1) and the first gate (G1-1), and a second insulating layer (20) disposed to cover the gate (G1-1), the source region (S1), and the drain region (D1),
wherein the pixel circuit further comprises a conductive pattern (P3) disposed on the metal oxide pattern (MOP),
wherein the second insulating layer (20) among the plurality of insulating layers (10, 20, 30, 40) is disposed between the first gate (G1-1) and the conductive pattern (P3), and
the first gate (G1-1) and the conductive pattern (P3) define a capacitor (C1).

2. The display device (DD) of claim 1, wherein:
the second insulating layer (20) has a first portion disposed between the first gate (G1-1) and the metal oxide pattern (MOP), a second portion disposed on the source region (S1), and a third portion disposed on the drain region (D1); and
the plurality of insulating layers (10, 20, 30, 40) comprise a third insulating layer (30) disposed on the second insulating layer (20) and the metal oxide pattern (MOP).

3. The display device (DD) of claim 2, wherein:
(i) the first insulating layer (10) comprises a silicon oxide layer,
the second insulating layer (20) comprises a silicon oxide layer or a silicon oxynitride layer, and
the third insulating layer (30) comprises a silicon oxynitride layer (31) and a silicon nitride layer (32) disposed on the silicon oxynitride layer (31); and/or
(ii) the second insulating layer (20) covers a side surface of the first insulating layer (10).

4. The display device (DD) of any one of claims 1 to 3, wherein the metal oxide pattern (MOP) is electrically connected to the first gate (G1-1).

5. The display device (DD) of any preceding claim, wherein:
(i) the first transistor (T1) controls a driving current of the light-emitting element (OLED) based on a charged capacitance of the capacitor (C1); and/or
(ii) the pixel circuit further comprises a second transistor (T2),
the second transistor (T2) comprises a metal oxide semiconductor pattern (SP), and
the second transistor (T2) supplies a data voltage (DS) to the capacitor (C1).

6. The display device (DD) of any preceding claim, wherein an edge of the metal oxide pattern (MOP) is aligned with an edge of the conductive pattern (P3).

7. The display device (DD) of any one of claims 1 to 6, wherein:
(i) the channel region (A1) has a length of about 3 µm or less; and/or
(ii) the first transistor (T1) further comprises a second gate (G1-2), and
the second gate (G1-2) is electrically connected to the first gate (G1-1) and disposed under the metal oxide semiconductor pattern (SP).

8. The display device (DD) of any one of claims 1 to 7, wherein:
(i) the metal oxide pattern (MOP) comprises at least one of indium (In), tin (Sn), zinc (Zn), gallium (Ga), magnesium (Mg), hafnium (Hf), or titanium (Ti); and/or
(ii) the metal oxide pattern (MOP) has a thickness of about 100 Å to about 300 Å.

9. A method for manufacturing a display device (DD), the method comprising:
forming, on a base layer (BS), a transistor (T1) including a metal oxide semiconductor pattern (SP) including a source region (S1), a drain region (D1), and a channel region (A1) disposed between the source region (S1) and the drain region (D1), a first insulating layer (10) disposed on the channel region (A1), and a gate (G1-1) disposed on the first insulating layer (10);
forming a second insulating layer (20) to cover the gate (G1-1), the source region (S1), and the drain region (D1);
forming a metal oxide layer (MOL) on the second insulating layer (20);
etching at least a portion of the metal oxide layer (MOL); and
forming a conductive pattern (P3) on the metal oxide pattern (MOP);
forming a third insulating layer (30) on the second insulating layer (20);
wherein the second insulating layer (20) is disposed between the first gate (G1-1) and the conductive pattern (P3), and
wherein the first gate (G1-1) and the conductive pattern (P3) define a capacitor (C1).

10. The method of claim 9, further comprising forming, on the metal oxide layer (MOL), a conductive pattern (P3) overlapping the gate (G1-1).

11. The method of claim 10, wherein in the etching of at least a portion of the metal oxide layer (MOL), the conductive pattern (P3) is used as a mask, and
a metal oxide pattern (MOP) overlapping the conductive pattern (P3) on a plane is formed from the metal oxide layer (MOL), optionally wherein an edge of the metal oxide pattern (MOP) is aligned with an edge of the conductive pattern (P3).

12. The method of any one of claims 9 to 11, wherein the forming of a metal oxide layer (MOL) uses sputtering, or metal organic chemical vapor deposition, MOCVD, with an oxygen gas having a partial pressure of about 50% to about 100% with respect to a reaction gas.

13. A method for manufacturing a display device (DD), the method comprising:
forming, on a base layer (BS), a transistor (T1) including a metal oxide semiconductor pattern (SP) including a source region (S1), a drain region (D1), and a channel region (A1) disposed between the source region (S1) and the drain region (D1), a first insulating layer (10) disposed on the base layer (BS) to cover the metal oxide semiconductor pattern (SP), and a gate (G1-1) disposed on the first insulating layer (10);
forming, on the first insulating layer (10), a metal oxide layer (MOL) to cover the gate (G1-1);
etching at least a portion of the metal oxide layer (MOL); and
then forming a second insulating layer (20) on the base layer (BS);
forming a conductive pattern (P3) on the second insulating layer (20);
wherein the second insulating layer (20) is disposed between the first gate (G1-1) and the conductive pattern (P3), and
wherein the first gate (G1-1) and the conductive pattern (P3) define a capacitor (C1).

## Patentansprüche

1. Anzeigevorrichtung (DD), umfassend:
eine Vielzahl von Isolierschichten (10, 20, 30, 40);
ein Leuchtelement (OLED); und
eine Pixelschaltung, die elektrisch mit dem Leuchtelement (OLED) verbunden ist,
wobei die Pixelschaltung einen ersten Transistor (T1) umfasst und
der erste Transistor (T1) umfasst
eine Metalloxid-Halbleiter-Struktur (SP), die einen Source-Bereich (S1), einen Drain-Bereich (D1) und einen Kanal-Bereich (A1), der zwischen dem Source-Bereich (S1) und dem Drain-Bereich (D1) angeordnet ist, beinhaltet,
ein erstes Gate (G1-1), das auf der Metalloxid-Halbleiter-Struktur (SP) angeordnet ist und den Kanalbereich (A1) in einer Ebene überlappt, und
eine Metalloxidstruktur (MOP), die auf dem ersten Gate (G1-1) angeordnet ist,
wobei die Vielzahl von Isolierschichten (10, 20, 30, 40) eine erste Isolierschicht (10), die zwischen dem Kanalbereich (A1) und dem ersten Gate (G1-1) angeordnet ist, und eine zweite Isolierschicht (20), die das Gate (G1-1), den Source-Bereich (S1) und den Drain-Bereich (D1) bedeckt, umfasst,
wobei die Pixelschaltung ferner eine auf der Metalloxidstruktur (MOP) angeordnete leitfähige Struktur (P3) umfasst,
wobei die zweite Isolierschicht (20) aus der Vielzahl von Isolierschichten (10, 20, 30, 40) zwischen dem ersten Gate (G1-1) und der leitfähigen Struktur (P3) angeordnet ist, und
das erste Gate (G1-1) und die leitfähige Struktur (P3) einen Kondensator (C1) definieren.

2. Anzeigevorrichtung (DD) nach Anspruch 1, wobei:
die zweite Isolierschicht (20) einen ersten Teil, der zwischen dem ersten Gate (G1-1) und der Metalloxidstruktur (MOP) angeordnet ist, einen zweiten Teil, der im Source-Bereich (S1) angeordnet ist, und einen dritten Teil, der im Drain-Bereich (D1) angeordnet ist, aufweist; und
die Vielzahl von Isolierschichten (10, 20, 30, 40) eine dritte Isolierschicht (30) umfasst, die auf der zweiten Isolierschicht (20) und der Metalloxidstruktur (MOP) angeordnet ist.

3. Anzeigevorrichtung (DD) nach Anspruch 2, wobei:
(i) die erste Isolierschicht (10) eine Siliziumoxidschicht umfasst,
die zweite Isolierschicht (20) eine Siliziumoxidschicht oder eine Siliziumoxynitridschicht umfasst und
die dritte Isolierschicht (30) eine Siliziumoxynitridschicht (31) und eine auf der Siliziumoxynitridschicht (31) angeordnete Siliziumnitridschicht (32) umfasst; und/oder
(ii) die zweite Isolierschicht (20) eine Seitenfläche der ersten Isolierschicht (10) bedeckt.

4. Anzeigevorrichtung (DD) nach einem der Ansprüche 1 bis 3, wobei die Metalloxidstruktur (MOP) elektrisch mit dem ersten Gate (G1-1) verbunden ist.

5. Anzeigevorrichtung (DD) nach einem vorstehenden Anspruch, wobei:
(i) der erste Transistor (T1) einen Ansteuerstrom des Leuchtelements (OLED) auf Basis einer geladenen Kapazität des Kondensators (C1) steuert; und/oder
(ii) die Pixelschaltung ferner einen zweiten Transistor (T2) umfasst,
der zweite Transistor (T2) eine Metalloxid-Halbleiter-Struktur (SP) umfasst und
der zweite Transistor (T2) eine Datenspannung (DS) an den Kondensator (C1) liefert.

6. Anzeigevorrichtung (DD) nach einem vorstehenden Anspruch, wobei eine Kante der Metalloxidstruktur (MOP) mit einer Kante der leitfähigen Struktur (P3) ausgerichtet ist.

7. Anzeigevorrichtung (DD) nach einem der Ansprüche 1 bis 6, wobei:
(i) der Kanalbereich (A1) eine Länge von etwa 3 µm oder weniger aufweist; und/oder
(ii) der erste Transistor (T1) ferner ein zweites Gate (G1-2) umfasst und
das zweite Gate (G1-2) elektrisch mit dem ersten Gate (G1-1) verbunden ist und unter der Metalloxid-Halbleiter-Struktur (SP) angeordnet ist.

8. Anzeigevorrichtung (DD) nach einem der Ansprüche 1 bis 7, wobei:
(i) die Metalloxidstruktur (MOP) mindestens eines von Indium (In), Zinn (Sn), Zink (Zn), Gallium (Ga), Magnesium (Mg), Hafnium (Hf) oder Titan (Ti) umfasst; und/oder
(ii) die Metalloxidstruktur (MOP) eine Dicke von etwa 100 Å bis etwa 300 Å aufweist.

9. Verfahren zur Herstellung einer Anzeigevorrichtung (DD), wobei das Verfahren umfasst:
Bilden, auf einer Basisschicht (BS), eines Transistors (T1), der eine Metalloxid-Halbleiter-Struktur (SP), die einen Source-Bereich (S1), einen Drain-Bereich (D1) und einen zwischen dem Source-Bereich (S1) und dem Drain-Bereich (D1) angeordneten Kanalbereich (A1) beinhaltet, eine erste Isolierschicht (10), die auf dem Kanalbereich (A1) angeordnet ist, und ein Gate (G1-1), das auf der ersten Isolierschicht (10) angeordnet ist, beinhaltet;
Bilden einer zweiten Isolierschicht (20), um das Gate (G1-1), den Source-Bereich (S1) und den Drain-Bereich (D1) zu bedecken;
Bilden einer Metalloxidschicht (MOL) auf der zweiten Isolierschicht (20);
Ätzen mindestens eines Teils der Metalloxidschicht (MOL); und
Bilden einer leitfähigen Struktur (P3) auf der Metalloxidstruktur (MOP);
Bilden einer dritten Isolierschicht (30) auf der zweiten Isolierschicht (20);
wobei die zweite Isolierschicht (20) zwischen dem ersten Gate (G1-1) und der leitfähigen Struktur (P3) angeordnet ist, und
wobei das erste Gate (G1-1) und die leitfähige Struktur (P3) einen Kondensator (C1) definieren.

10. Verfahren nach Anspruch 9, ferner umfassend Bilden, auf der Metalloxidschicht (MOL), einer leitfähigen Struktur (P3), die das Gate (G1-1) überlappt.

11. Verfahren nach Anspruch 10, wobei beim Ätzen mindestens eines Teils der Metalloxidschicht (MOL) die leitfähige Struktur (P3) als Maske dient und
eine Metalloxidstruktur (MOP), die die leitfähige Struktur (P3) in einer Ebene überlappt, aus der Metalloxidschicht (MOL) gebildet wird, wobei optional eine Kante der Metalloxidstruktur (MOP) mit einer Kante der leitfähigen Struktur (P3) ausgerichtet ist.

12. Verfahren nach einem der Ansprüche 9 bis 11, wobei das Bilden einer Metalloxidschicht (MOL) durch Sputtern oder metallorganische chemische Gasphasenabscheidung, MOCVD, mit einem Sauerstoffgas erfolgt, das einen Partialdruck von etwa 50 % bis etwa 100 % in Bezug auf ein Reaktionsgas aufweist.

13. Verfahren zur Herstellung einer Anzeigevorrichtung (DD), wobei das Verfahren umfasst:
Bilden, auf einer Basisschicht (BS), eines Transistors (T1), der eine Metalloxid-Halbleiter-Struktur (SP), die einen Source-Bereich (S1), einen Drain-Bereich (D1) und einen zwischen dem Source-Bereich (S1) und dem Drain-Bereich (D1) angeordneten Kanalbereich (A1) beinhaltet, eine erste Isolierschicht (10), die auf der Basisschicht (BS) angeordnet ist, um die Metalloxid-Halbleiter-Struktur (SP) abzudecken, und ein Gate (G1-1), das auf der ersten Isolierschicht (10) angeordnet ist, beinhaltet;
Bilden, auf der ersten Isolierschicht (10), einer Metalloxidschicht (MOL), die das Gate (G1-1) bedeckt;
Ätzen mindestens eines Teils der Metalloxidschicht (MOL); und
dann Bilden einer zweiten Isolierschicht (20) auf der Basisschicht (BS);
Bilden einer leitfähigen Struktur (P3) auf der zweiten Isolierschicht (20);
wobei die zweite Isolierschicht (20) zwischen dem ersten Gate (G1-1) und der leitfähigen Struktur (P3) angeordnet ist, und
wobei das erste Gate (G1-1) und die leitfähige Struktur (P3) einen Kondensator (C1) definieren.

## Revendications

1. Dispositif d'affichage (DD) comprenant :
une pluralité de couches isolantes (10, 20, 30, 40) ;
un élément électroluminescent (OLED) ; et
un circuit de pixel connecté électriquement à l'élément électroluminescent (OLED),
dans lequel le circuit de pixel comprend un premier transistor (T1), et
le premier transistor (T1) comprend
un motif semi-conducteur à oxyde métallique (SP) incluant une région de source (S1), une région de drain (D1) et une région de canal (A1) disposée entre la région de source (S1) et la région de drain (D1),
une première grille (G1-1) disposée sur le motif semi-conducteur à oxyde métallique (SP), et chevauchant la région de canal (A1) sur un plan, et
un motif à oxyde métallique (MOP) disposé sur la première grille (G1-1),
dans lequel la pluralité de couches isolantes (10, 20, 30, 40) comprennent une première couche isolante (10) disposée entre la région de canal (A1) et la première grille (G1-1), et une deuxième couche isolante (20) disposée pour recouvrir la grille (G1-1), la région de source (S1), et la région de drain (D1),
dans lequel le circuit de pixel comprend en outre un motif conducteur (P3) disposé sur le motif à oxyde métallique (MOP),
dans lequel la deuxième couche isolante (20) parmi la pluralité de couches isolantes (10, 20, 30, 40) est disposée entre la première grille (G1-1) et le motif conducteur (P3), et
la première grille (G1-1) et le motif conducteur (P3) définissent un condensateur (C1).

2. Dispositif d'affichage (DD) selon la revendication 1, dans lequel :
la deuxième couche isolante (20) présente une première partie disposée entre la première grille (G1-1) et le motif à oxyde métallique (MOP), une deuxième partie disposée sur la région de source (S1), et une troisième partie disposée sur la région de drain (D1) ; et
la pluralité de couches isolantes (10, 20, 30, 40) comprennent une troisième couche isolante (30) disposée sur la deuxième couche isolante (20) et le motif à oxyde métallique (MOP).

3. Dispositif d'affichage (DD) selon la revendication 2, dans lequel :
(i) la première couche isolante (10) comprend une couche d'oxyde de silicium,
la deuxième couche isolante (20) comprend une couche d'oxyde de silicium ou une couche d'oxynitrure de silicium, et
la troisième couche isolante (30) comprend une couche d'oxynitrure de silicium (31) et une couche de nitrure de silicium (32) disposée sur la couche d'oxynitrure de silicium (31) ; et/ou
(ii) la deuxième couche isolante (20) recouvre une surface latérale de la première couche isolante (10).

4. Dispositif d'affichage (DD) selon l'une quelconque des revendications 1 à 3, dans lequel le motif à oxyde métallique (MOP) est connecté électriquement à la première grille (G1-1).

5. Dispositif d'affichage (DD) selon une quelconque revendication précédente, dans lequel :
(i) le premier transistor (T1) commande un courant d'excitation de l'élément électroluminescent (OLED) sur la base d'une capacitance chargée du condensateur (C1) ; et/ou
(ii) le circuit de pixel comprend en outre un second transistor (T2),
le second transistor (T2) comprend un motif semi-conducteur à oxyde métallique (SP), et
le second transistor (T2) fournit une tension de données (DS) au condensateur (C1).

6. Dispositif d'affichage (DD) selon une quelconque revendication précédente, dans lequel un bord du motif à oxyde métallique (MOP) est aligné sur un bord du motif conducteur (P3).

7. Dispositif d'affichage (DD) selon l'une quelconque des revendications 1 à 6, dans lequel :
(i) la région de canal (A1) présente une longueur d'environ 3 µm ou moins ; et/ou
(ii) le premier transistor (T1) comprend en outre une seconde grille (G1-2), et
la seconde grille (G1-2) est connectée électriquement à la première grille (G1-1) et disposée sous le motif semi-conducteur à oxyde métallique (SP).

8. Dispositif d'affichage (DD) selon l'une quelconque des revendications 1 à 7, dans lequel :
(i) le motif à oxyde métallique (MOP) comprend au moins un parmi de l'indium (In), de l'étain (Sn), du zinc (Zn), du gallium (Ga), du magnésium (Mg), de l'hafnium (Hf), ou du titane (Ti) ; et/ou
(ii) le motif à oxyde métallique (MOP) présente une épaisseur d'environ 100 Å à environ 300 Å.

9. Procédé de fabrication d'un dispositif d'affichage (DD), le procédé comprenant :
la formation, sur une couche de base (BS), d'un transistor (T1) incluant un motif semi-conducteur à oxyde métallique (SP) incluant une région de source (S1), une région de drain (D1) et une région de canal (A1) disposée entre la région de source (S1) et la région de drain (D1), une première couche isolante (10) disposée sur la région de canal (A1), et une grille (G1-1) disposée sur la première couche isolante (10) ;
la formation d'une deuxième couche isolante (20) pour recouvrir la grille (G1-1), la région de source (S1) et la région de drain (D1) ;
la formation d'une couche d'oxyde métallique (MOL) sur la deuxième couche isolante (20) ;
la gravure d'au moins une partie de la couche d'oxyde métallique (MOL) ; et
la formation d'un motif conducteur (P3) sur le motif à oxyde métallique (MOP) ;
la formation d'une troisième couche isolante (30) sur la deuxième couche isolante (20) ;
dans lequel la deuxième couche isolante (20) est disposée entre la première grille (G1-1) et le motif conducteur (P3), et
dans lequel la première grille (G1-1) et le motif conducteur (P3) définissent un condensateur (C1).

10. Procédé selon la revendication 9, comprenant en outre la formation, sur la couche d'oxyde métallique (MOL), d'un motif conducteur (P3) chevauchant la grille (G1-1).

11. Procédé selon la revendication 10, dans lequel, lors de la gravure d'au moins une partie de la couche d'oxyde métallique (MOL), le motif conducteur (P3) est utilisé comme masque, et
un motif à oxyde métallique (MOP) chevauchant le motif conducteur (P3) sur un plan est formé à partir de la couche d'oxyde métallique (MOL), optionnellement dans lequel un bord du motif à oxyde métallique (MOP) est aligné sur un bord du motif conducteur (P3).

12. Procédé selon l'une quelconque des revendications 9 à 11, dans lequel la formation d'une couche d'oxyde métallique (MOL) utilise la pulvérisation cathodique, ou le dépôt chimique en phase vapeur par composés organométalliques, MOCVD, avec un gaz oxygène présentant une pression partielle d'environ 50 % à environ 100 % par rapport à un gaz de réaction.

13. Procédé de fabrication d'un dispositif d'affichage (DD), le procédé comprenant :
la formation, sur une couche de base (BS), d'un transistor (T1) incluant un motif semi-conducteur à oxyde métallique (SP) incluant une région de source (S1), une région de drain (D1) et une région de canal (A1) disposée entre la région de source (S1) et la région de drain (D1), une première couche isolante (10) disposée sur la couche de base (BS) pour recouvrir le motif semi-conducteur à oxyde métallique (SP), et une grille (G1-1) disposée sur la première couche isolante (10) ;
la formation, sur la première couche isolante (10), d'une couche d'oxyde métallique (MOL) pour recouvrir la grille (G1-1) ;
la gravure d'au moins une partie de la couche d'oxyde métallique (MOL) ; et
ensuite la formation d'une deuxième couche isolante (20) sur la couche de base (BS) ;
la formation d'un motif conducteur (P3) sur la deuxième couche isolante (20) ;
dans lequel la deuxième couche isolante (20) est disposée entre la première grille (G1-1) et le motif conducteur (P3), et
dans lequel la première grille (G1-1) et le motif conducteur (P3) définissent un condensateur (C1).
